# EUROPEAN PATENT APPLICATION

(11) **EP 2 933 843 A1**
(43) Date of publication of application: **21.10.2015**
(21) Application number: 14165272.7
(22) Date of filing: 17.04.2014
(51) Int. Cl.: H01L 31/0216, H01L 31/0236

(54) **Solar cell and method for manufacturing such a solar cell**

(71) Applicant: TOTAL MARKETING SERVICES, 92800 Puteaux (FR)
(72) Inventor: Damon-Lacoste, Jerome, 92160 Antony (FR)
(74) Representative: Croonenbroek, Thomas Jakob

(57) **Abstract**

The invention relates to a solar cell (1) comprising a semiconductor substrate and a layer comprising light-scattering submicron oxide particles (13) disposed on said semiconductor substrate (3).

## Description

### FIELD OF THE INVENTION

The invention relates to a solar cell and to a method for manufacturing a solar cell.

### BACKGROUND AND PRIOR ART

Solar cells are well known devices for converting solar radiation to electrical energy. A solar cell has a front side that faces the sun during normal operation to collect solar radiation and a backside opposite the front side. Solar radiation impinging on the solar cell creates electrical charges that may be harnessed to power an external electrical circuit, such as a load. The external electrical circuit may receive electrical current from the solar cell by way of metal fingers that are connected to doped regions of the solar cell.

Renewable energy sources like solar panels and/or solar cells are now widely used for generation of electricity. However, efficiency at lowest manufacturing cost is an ongoing challenge for the solar cell industry.

One of the challenging items concerns light coupling into the wafer substrate (a semiconductor substrate for example made of crystalline silicon for generating current), reducing losses from reflection from its front surface and improving absorption probability of the incident photons.

In view of this, a solar cell is generally equipped with an antireflection coating in order to decrease reflection when light rays impinge the solar cell.

Furthermore, the underlying wafer substrate is also textured which in addition improves the performance of a solar cell.

Texturing has the effect that the incident photons strike the cell surface at different angles which improves the probability of absorption and reduced also reflection losses through the fact of multiple reflections.

In addition, photons refracted into the silicon will propagate at an angle and the wider this angle, the longer the optical path of the photons increasing their probability to create electron/hole pairs. Increasing the optical path lengths of photons by increasing the scattering is a method to better absorb the solar spectrum.

Finally, when long-wavelength photons are reflected from the rear surface back to the front, they will hit an angled silicon surface, improving the chance of being internally reflected which stills improve the absorption probability.

Single-crystal silicon solar cells are generally textured with random pyramids, which are produced by etching in an alkaline solution such as KOH or NaOH. This is made possible by the anisotropic (i.e. orientation dependent) nature of these etching solutions, in conjunction with an appropriate choice of the crystal plane orientation at the wafer surface.

EP 1 167 313 discloses a low reflective glass article such as solar cell glass base substrates.

In this document, a low reflection film comprising silica fine particles and a binder is obtained by mixing starting fine particles comprising non-aggregated silica fine particles with a mean particle size of 40-1000 nm and/or linear(chain-like) aggregated silica fine particles with a mean primary particle size of 10-100 nm. The prepared coating solution is coated onto a glass base substrate and subjecting it to heat treatment.

EP 1 167 313 discloses therefore a general antireflection coating disposed on a glass substrate.

US 8 148 194 relates to a solar cell comprising a semiconductor substrate of one conductivity-type, a layer of the opposite conductivity-type provided on a surface side of the semiconductor substrate, a surface electrode formed thereon, and a backside electrode formed on a backside of the semiconductor substrate. The semiconductor substrate is formed with protrusions and recesses on the surface side thereof, and spaces that are filled with a glass component of an electrode material of the surface electrode are present in bottom portions of the recesses.

The glass component (glass frit) is a silver paste comprising silver powder having particles.

In this case, the disposed particles enhance the electrode properties at the electrode locations but do not enhance light coupling inside the solar cell or improve absorption probability.

WO2011023894 relates to a method for texturing the surface of a gaseous phase silicon substrate, and to a textured silicon substrate for a solar cell.

The document by Martin A Green, Jianhua Zhao, Aihua Wang, and Stuart R. Wenham, IEEE Transactions on Electronic Devices, vol 46, No 10, pp 1940-1947 (1999) discloses a method of photolithography and wet etching that can produce a c-Si (100) silicon substrate with structures in the form of inverted pyramids on its surface.

US 2012/0329200 discloses a method of texturing a surface of a crystalline silicon substrate.

However, in order to decrease costs of solar cells, the thickness of the wafer tends to be reduced to less than 130µm, typically less than 100µm and even as thin as 60µm.

With respect to these thin wafers, two conflicting problems may arise.

Texturing causes silicon of the wafer to be removed. Thus, the efficient absorption thickness of the silicon wafer is reduced and therefore also the portion of silicon able to absorb the impinging photons while rendering the wafer mechanically more fragile.

One solution might be a rough texturing with structures less important and removing therefore less silicon but then anti-reflexion is less performing and the efficiency of the solar cell may decrease because the current decreases.

An object of the invention is thus to provide a solar cell with improved performance.

It is particularly advantageous for solar cells made of a thin wafer, textured or not, in order to enhance efficiency.

The present invention focusses on improving efficiency of solar cells.

For this purpose, the invention proposes a solar cell comprising a semiconductor substrate and a layer comprising submicron oxide light scattering particles disposed on said semiconductor substrate.

Thanks to the invention, before impinging the semi-conductor substrate, the incoming light undergoes additional scattering that allows enhancing to couple the incoming light into the semiconductor substrate. The surface of the substrate wafer is therefore treated efficiently for enhancing light coupling directly into the semiconductor substrate wafer for conversion into electricity at lower costs and without increasing the risk of mechanical breach of the wafer during manufacturing.

In particular through mainly Mie scattering and/or Rayleigh diffusion by the particles that are present on the surface of the semiconductor substrate, the optical path is increased raising therefore their probability to create electron/hole pairs. Increasing the optical path lengths of photons by increasing the scattering is a method to better absorb the solar spectrum.

The scattered power is maximized if the particles are about the size of the scattered wavelength. Therefore it is advantageous that the particles are of submicron size with respect the solar spectrum to be scattered.

By the way, reflection losses are also reduced.

In addition, the proposed solar cell is cost competitive.

The solar cell may present the following aspects taken alone or in combination.

According to another aspect, the submicron oxide particles are transparent in the working bandwidth of wavelength of the solar cell.

The semiconductor substrate may be textured and in this case, the textured structures may have a height or depth with regard to the mean surface of the semiconductor substrate comprised between 1-6 µm.

According to another aspect, the submicron oxide particles have a spherical shape.

Furthermore the submicron oxide particles have for example a mean diameter of less than 1µm, but superior to 35 nm, for example of about 80 nm.

Alternatively the submicron oxide particles have a mean diameter of about 800 nm.

According to one development a first group of submicron oxide particles have a mean diameter of about 80 nm and second group of submicron oxide particles have a mean diameter of about 800 nm.

The submicron oxide particles are for example made of a metal oxide, in particular TiO₂ or SnO, ZnO, InO₂.

Their refractive index may be comprised between 1.5 and 2.6 in the solar spectrum.

According to another aspect an anti-reflection coating is applied on the layer comprising said submicron oxide particles, the layer being disposed on the semiconductor substrate.

According to a further aspect the semiconductor substrate has a thickness of less than 130µm.

The mean distance between particles disposed on the substrate is for example inferior to two times the mean diameter of the submicron oxide particles.

The invention also relates to a method for manufacturing a solar cell as described above comprising the step of disposal of submicron oxide particles on a semiconductor substrate.

The submicron oxide particles may be disposed on the semiconductor substrate by screen printing, slot-die coating, Doctor Blade coating, or jet dispersion.

### BRIEF DESCRIPTIONS OF THE DRAWINGS

Other advantages and characteristics will appear with the reading of the description of the following figures, among which:
- FIG. 1 is a pictorial representation (through a cross sectional view) illustrating schematically a solar cell according to a first embodiment of the present disclosure,
- FIG. 2 is a pictorial representation (through a cross sectional view) illustrating schematically the substrate surface of a solar cell according to a second embodiment of the present disclosure,
- FIG. 3 is a pictorial representation (through a cross sectional view) illustrating schematically the substrate surface of a solar cell according to figure 2 in order to explain the effect of the particles on the impinging light rays and
- FIG. 4 is a pictorial representation (through a cross sectional view) illustrating schematically the substrate surface of a solar cell according to a third embodiment of the present disclosure.

### DETAILED DESCRIPTION

On all the figures the same references refer to the same elements.

In the present description "mean diameter" of a particle means normalized D50 mean diameter. It is the value of the particle diameter at 50% in the cumulative distribution. For example, if D50=80nm, then 50% of the particles in the sample are larger than 80nm, and 50% smaller than 80nm. The particle size may be measured in dilute aqueous dispersions with a HORIBA LA-900 (TM). The characterization tool from Horiba uses Mie scattering theory to measure "equivalent spherical diameter" as a function of transmission percentage and scattered light. The size of the particle determines where the light is scattered. Therefore, by measuring the transmission percentage, front scatter, side scatter, and back scatter the size of the particle can be calculated.

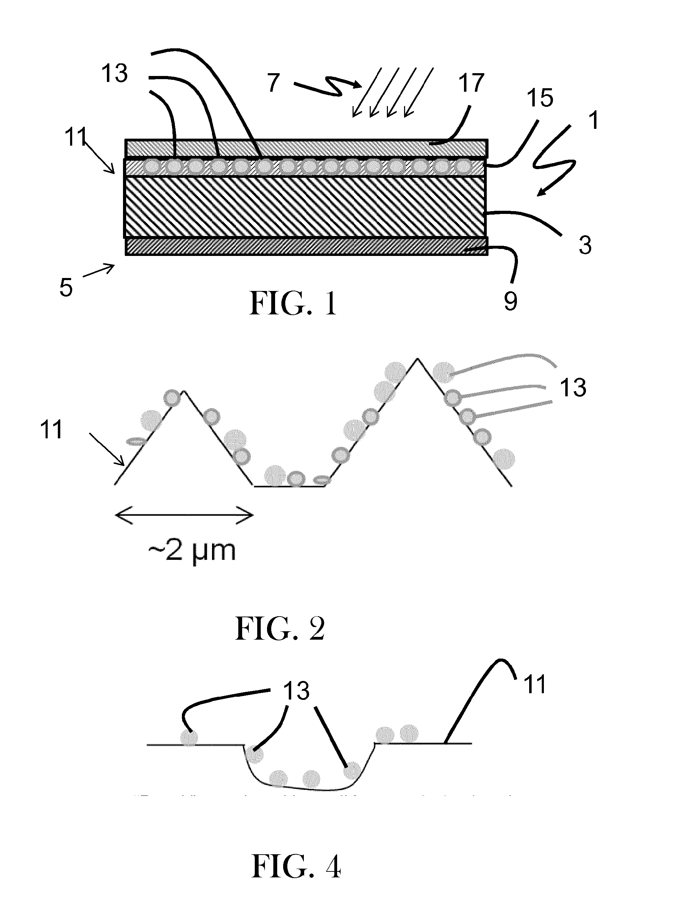

FIG. 1 shows a pictorial representation through a cross sectional view illustrating schematically a solar cell 1 according to a first embodiment of the present disclosure.

The solar cell 1 comprises a semiconductor substrate 3, for example a crystalline silicon substrate, having in a known manner doped layers, like a p-type doped layer and a n-type doped layer where at the junction photons are absorbed and an electron - hole pair is generated for current generation.

As known, p-type doped layer includes for example impurities like boron, aluminum, gallium and indium in concentrations of about 10⁹ atoms/cm³ to 10²⁰ atoms/cm³.

N-type doped layers contain impurities like antimony, arsenic and phosphorous and can be present in the same concentration range as the p-type doped layer.

Manufacturing of the semiconductor substrate with its doped zones is well known and will not be detailed here.

However, it should be noted that the semiconductor substrate may have a thickness of less than 130µm, meaning that the present application applies advantageously to very thin solar cells.

As to present understanding, the thickness of less than 130µm for the semiconductor substrate 3 is the thickness of the wafer at the beginning of the solar cell manufacturing process, before any etching process applied to the substrate.

The present invention applies in particular to semiconductor substrates having a thickness less than 100µm and even very thin wafers like epitaxial foils with thicknesses less than 60µm.

On the backside 5 of the semiconductor substrate 3 (with respect to the incident light rays 7) is implemented a reflection layer 9.

On the frontside 11 of the semiconductor substrate 3 (with respect to the incident light rays 7), a layer comprising light scattering submicron oxide particles 13 (for clarity of the figure, only some particles are referenced) is disposed on the semiconductor substrate 3. These particles 13 are individually transparent in the working bandwidth of wavelength of the solar cell 1. Transparency of the particles 13 allows scattering of light (mainly in the direction of the wafer) with nearly no absorption or as few absorption as possible.

Thus, the particles 13 can:
- capture impinging light rays that couple into the particles in particular through Mie-Scattering effect, or
- can diffuse light on the basis of the Rayleigh diffusion.

Then the diffused or scattered light rays penetrate into the substrate wafer for absorption and creation of a current through the photovoltaic effect. Thanks to both effects on the photons by particles 13, the optical path of the photons is increased raising therefore their probability to create electron/hole pairs. Thus, the efficiency of the solar cell is enhanced.

The working bandwidth of the solar cell 1 is for example from around 350nm to 1150nm.

Therefore in addition to the known steps for manufacturing a solar cell 1, the present method comprises an additional the step of disposal of a layer comprising submicron oxide particles 13 on the semiconductor substrate 3.

The submicron oxide particles 13 have preferentially a spherical shape because in this case, they are most efficient according to Mie Scattering theory to couple the incident light rays 7 into the semiconductor substrate 3.

The mean diameter of particles 13 is less than 1µm.

In order to couple preferentially high energy blue incident light rays, the particles 13 have a mean diameter superior to 35nm, for example of about 80nm.

In order to couple preferentially lower energy red incident light rays, the particles 13 have a mean diameter of about 800nm.

In figure 1, the particles 13 are disposed on the planar semiconductor frontside.

In particular in this, case, it can be advantageous to dispose at least two groups of particles 13 of different mean diameter on the semiconductor substrate 3, each group being dedicated to enhance light diffusion or light scattering in a specific part of the solar light spectrum that may be absorbed by solar cell 1.

For example a first group of submicron oxide particles, adapted to enhance Mie scattering in the blue part of the solar spectrum, may have a mean diameter of about 80nm and a second group of submicron oxide particles, adapted to enhance Mie scattering in the IR part of the solar spectrum may have a mean diameter of about 800nm.

Thus, thanks to two different groups of particles 13, almost the whole working bandwidth of the solar cell 1 can be covered more efficiently as particles of 80nm are more adapted for coupling light of shorter wavelength (blue light) into the wafer whereas particles of 800nm are more appropriate for coupling light of longer wavelength (red light) into the wafer.

More specifically, the submicron oxide particles 13 can be made of a metal oxide like for example TiO₂ or SnO, ZnO, InO₂. These metal oxide are for example commercialized in a powder form. They are known as Transparent Conductive Oxide in the photovoltaic community. The particles 13 have a refractive index comprised between 1.5 and 2.6, in particular between 1.8 and 2.6 within the solar spectrum range.

According to one embodiment the layer comprising the submicron oxide particles 13 is disposed on the semiconductor substrate 3 by screen printing. In this case, the particles 13 are embedded in a paste applied by screen printing.

According to another embodiment the submicron oxide particles 13 are disposed on the semiconductor substrate 3 by slot-die coating. In this case, the particles are embedded in a resin.

In figure 1, the particles 13 are shown in their layer for example of resin 15.

Both methods have the advantage to be easy to handle and to be at low cost.

Other methods may be used, for example a method known as Doctor Blade coating or also jet dispersion.

The layer comprising the submicron oxide particles 13 is disposed in a way that the mean distance between particles is inferior to two times the mean diameter of the particles 13, in particular inferior to the mean diameter of the particles 13.

In case of several groups of particles 13 with different mean diameters, the submicron oxide particles 13 are disposed with a mean distance inferior to two times the mean diameter of the group of particles 13 having the smallest mean diameter.

Furthermore, an anti-reflection coating 17 is in general applied on the layer comprising the submicron particles 13.

We are turning now to figure 2 showing a second embodiment, where only the frontside 11 of the semiconductor substrate 3 is represented with the layer comprising the submicron oxide particles disposed thereon.

The difference from the embodiment of figure 1 is that the semiconductor substrate has been roughly textured previously, before disposal of the layer comprising particles 13. Therefore rough texturing and the layer comprising the particles 13 are combined.

A rough or slight texturing, means that the textured structures have a height or depth with regard to the mean surface of the semiconductor substrate 3 comprised between 1-5µm, preferentially between 1-2.5µm. In this case rough texturing only conducts to slight consumption of underlying silicon of the semiconductor substrate 3. The disposal of the submicron oxide particles enhances coupling of photons in the semiconductor substrate 3. Additionally, it also compensates at least partially for the reflection losses.

The rough texturing process may be a chemical one, for example based on KOH IPA or TMAH, but also plasma texturing is possible.

Due to the submicron oxide particles spread at the surface of the semiconductor substrate 3, scattering of light is increased thanks to the fact that the impinging light rays are scattered by the particles 13 through Mie scattering mainly and / or Rayleigh diffusion and coupling the light in the underlying silicon substrate 3.

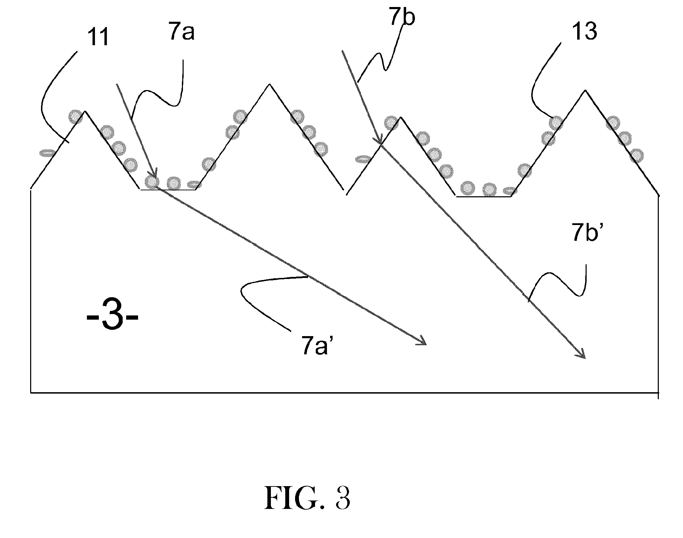

This is shown in fig 3 where two incident light rays 7a and 7b are represented. Light ray 7a hits a particle 13 disposed on the semiconductor substrate 3 and is scattered by the particle 13 whereas light ray 7b only impinges on the rough textured surface 11 of the semiconductor substrate 3.

One can see that the deviation 7a' of light ray 7a is more important than the deviation 7b' of light ray 7b resulting in an increase of optical path within the semiconductor substrate 3, increasing therefore the absorption probability.

Depending on the kind of features obtained after the texturing process and depending on the reflection's spectrum, one will adapt the average size's distribution of the particles 13 or even use two kinds of particles 13.

Figure 4 shows an example with a similar representation to figure 2 where the semiconductor substrate is an epitaxial foil for example a crystalline silicon epitaxial foil of less than 60µm.

The epitaxial foil has been roughly textured with impacts have dimensions less than 1µm. The particles 13 are disposed on the frontside 11 of the semiconductor substrate 3 and within the impacts.

The above described method is less costly than classical plasma texturing. Especially, it enables to significantly enhance coupling of light rays into the semiconductor substrate 3. It also decreases the reflection even with a rough/fast wet texturing process. The high mechanical risks of classical etch processes for thin silicon wafers or foils are eliminated. The mechanical breakage/damage rate of these thin semiconductor substrates is decreased.

Thanks to the above described method, an increase in the short circuit current Jsc could go from 0.3 -1 mA/cm² for one particle type and from 0.5 - 3 mA/cm² for two particles types, therefore an increase of efficiency of 1% to 3% relatively for a solar cell 1.

## Claims

1. Solar cell (1) comprising a semiconductor substrate (3) and a layer comprising light scattering submicron oxide particles (13) disposed on said semiconductor substrate (3).

2. Solar cell as to claim 1, where the submicron oxide particles (13) are made of a metal oxide, in particular TiO₂ or SnO, ZnO, InO₂.

3. Solar cell (1) as to any of claims 1 to 3 where the light scattering submicron oxide particles (13) are transparent in the working bandwidth of wavelength of the solar cell.

4. Solar cell (1) as to any of claims 1 to 3, where the semiconductor substrate (3) is textured.

5. Solar cell (1) as to claim 4, where the textured structures have a height or depth with regard to the mean surface of the semiconductor substrate (3) comprised between 1-6 µm.

6. Solar cell as to any preceding claims, where the light scattering submicron oxide particles (13) have a spherical shape.

7. Solar cell as to any preceding claims, where the light scattering submicron oxide particles (13) have a mean diameter of less than 1µm.

8. Solar cell as to claim 7, where the light scattering submicron oxide particles (13) have a mean diameter superior to 35 nm, for example of about 80 nm.

9. Solar cell as to claim 7, where the light scattering submicron oxide particles (13) have a mean diameter of about 800 nm.

10. Solar cell as to claim 8 and 9, where a first group of light scattering submicron oxide particles (13) have a mean diameter of about 80 nm and second group of light scattering submicron oxide particles (13) have a mean diameter of about 800 nm.

11. Solar cell as to any preceding claims, where the light scattering submicron oxide particles (13) have a refractive index comprised between 1.5 and 2.6 in the solar spectrum.

12. Solar cell as to any preceding claims, where an anti-reflection coating (17) is applied on layer comprising the light scattering submicron oxide particles (13), disposed on the semi-conductor substrate (3).

13. Solar cell as to any preceding claims, where the semiconductor substrate (3) has a thickness of less than 130µm.

14. Solar cell as to any preceding claims, where the mean distance between particles (13) disposed on the substrate (3) is inferior to two times the mean diameter of the submicron oxide particles (13).

15. Solar cell as to any preceding claims, where the semiconductor substrate (3) is a crystalline silicon substrate.

16. Method for manufacturing a solar cell (1) as to any of claims 1 to 15 comprising the step of disposal of light scattering submicron oxide particles (13) on a semiconductor substrate (3).

17. Method as to claim 16, where the light scattering submicron oxide particles (13) are disposed in a layer on the semiconductor substrate (3) by screen printing, slot-die coating, Doctor Blade coating, or jet dispersion.
